# EUROPEAN PATENT SPECIFICATION

(11) **EP 1 605 504 B1**
(45) Date of publication and mention of the grant of the patent: **25.05.2011**
(21) Application number: 04291457.2
(22) Date of filing: 10.06.2004
(51) Int. Cl.: H01L 21/762

(54) **Method for manufacturing a SOI wafer**
Verfahren für das Herstellen eines SOI Wafers
Procédé pour la fabrication d'une tranche SOI

(43) Date of publication of application: 14.12.2005
(60) Divisional application: 10013020.2
(73) Proprietor: S.O.I. Tec Silicon on Insulator Technologies S.A., 38190 Bernin (FR)
(72) Inventor: Maurice, Thibaut, c/o S.O.I. Tec Silicon on ..., 38190 Bernin (FR); Nguyen, Phuong, c/o S.O.I. Tec Silicon on ..., 38190 Bernin (FR); Guiot, Eric, c/o S.O.I. Tec Silicon on..., 38190 Bernin (FR)
(74) Representative: Grünecker, Kinkeldey, Stockmair & Schwanhäusser Anwaltssozietät

(56) References cited:
- WO-A-2004/042779
- US-A- 6 020 252
- US-A1- 2003 124 815
- US-B1- 6 344 404
- MAT RES INNOVAT, vol. 3, 1999, pages 9-13, XP002294551

## Description

The invention relates to a method for manufacturing material compound wafers, in particular a semiconductor on quartz type material compound wafer.

A method according to the preamble of claim 1 is known from US 2003/124815 A1.

Such a material compound wafer can be fabricated with a SmartCut technology which can be adapted to material compounds wafers, like also heterostructures. Such an adaptation is necessary to take into account stress inside the material compound wafers as heterostructures may have sufficiently different physical properties, like for example different thermal expansion coefficients. This stress can lead to bad quality or even to completely destructed samples.

The SmartCut technology comprises three main process steps which are: a) forming a predetermined splitting area in a source substrate, b) attaching the source substrate to a handle substrate to form a source handle compound, and c) fragilising the predetermined splitting area until detachment by providing energy, in particular in the form of thermal energy.

Due to the fact that a material compound wafer is composed of materials usually having different physical properties, like the thermal expansion co-efficient, the thermal annealing step leading to the final detachment cannot always be carried out completely. Actually this would lead to excessive stress inside the source-handle-compound. To solve this problem it has been proposed, like for example in FR2797347, to separate the fragilisation/detachment step into two parts. The first one consists of a thermal treatment to fragilise the predetermined splitting area and the second step consists of physically detaching the source substrate at the predetermined splitting area from the source-handle-compound during which the transfer of a thin film from the source substrate onto the handle substrate takes place. During the fragilisation step the predetermined splitting area becomes weaker and weaker. However, the thermal budget, being the combination out of temperature and time, necessary for complete detachment is not completely applied to prevent negative consequences due to the presence of high stress inside the source-handle-compound. After the fragilisation step the source-handle-compound is cooled down to room temperature to carry out the final detachment step, which consists in providing additional energy, in particular in the form of mechanical energy, to achieve the physical detachment. To do so a blade is introduced at the weakened plane to supply the necessary energy.

With the proposed process it is possible to create material compound wafers of the required type, even if the thermal expansion coefficients are different. However, it is observed that the quality of the final product is not always good enough during the mass production process which leads to unsatisfying production yields and thus an increase in costs per good wafer. In the mass production process, the wafers are thermally treated by groups of 25 or more, wherein 100 wafers is a common a mount. Thereafter, each wafer has to be mechanically split with splitting equipment at room temperature, e.g. with a blade. The furnace is then free for further utilization. With this kind of production, an increased roughness has been observed. The transferred layer does not fully cover the surface of the handle substrate and said free zone, called exclusion zone, is large and the rim of the transferred layer has large irregularities at its circumference. All this leads to a reduced quality of the product.

It is therefore the object of the present invention to provide a method for manufacturing material compounds wafers, in particular a semiconductor on quartz type material compound wafer, which, compared to the standard process, is further optimized, that is, with which higher production yield and a better quality can be obtained.

This object is achieved with the method for manufacturing a material compound wafer according to claim 1.

The mechanical splitting at this detachment temperature leads to better wafer quality. Defects created by the detachment process during the prior art process are reduced, in particular those defects created by the introduction of the blade which in the state of the art process lead to the enhanced roughness of the wafer surface and large exclusion zones with irregular circumferences.

In this application, the term "room temperature" relates to temperatures that are in a range of about 18°C to 25°C, corresponding to typical clean room temperatures. The term "degree of weakening" in this application is employed as a measure of strength of the weakened predetermined splitting area, when the two parts of the source substrate with the splitting area in between are still connected with each other.

According to an advantageous embodiment, the detachment temperature is below 150°C, preferably below 50°C. Below 150°C, it is possible to keep the degree of weakening basically at the same level and further undesired stress is avoided. A mechanical splitting by means of a blade can be performed smoothly with only a few defects of enhanced roughness. If the mechanical splitting occurs at or below 50°C, the creation of bows in case of silicon and quartz wafers due to different thermal expansion coefficients is basically prevented and the wafers obtained have a low roughness.

According to a variant of the invention, the source-handled compound is stored between step c) and step d) at a storing temperature higher than room temperature at which the predetermined splitting area stays with essentially the same degree of weakening during the storing. As the storing temperature is chosen such that no further weakening occurs, no further stress is applied to the material compound wafer and defects such as blue blistering or cracks are prevented. The wafers can be stored over a considerable time at said storing temperature and are kept in a state which allows a mechanical splitting leading to low roughness.

Advantageously, storing can take place at a temperature of about 50°C to about 150°C, in particular from about 50°C to about 140°C or even more in particular from about 70°C to 120°C. In this temperature regime the thermal budget provided to the bonded structure is sufficiently low to keep the degree of weakening more or less constant to prevent further stress, whereas on the other side the providing of additional energy to create the detachment, like an introduction of a blade, does not lead to the above-mentioned defects of enhanced roughness and lower product quality. Thus within the mentioned temperature range the production yield of good quality material compound wafers can further be increased.

According to a preferred embodiment the storing can take place under a neutral atmosphere, such as for example under argon or nitrogen gas. Storing under the neutral atmosphere will prevent chemical reactions to take place which may alter the required properties of the material compound wafer.

Preferably the storage can take place in a furnace. A furnace has the advantage that a large number of wafers can be stored at the same time. The furnace used may actually be the same as the one in which the thermal annealing takes place, with the difference that during the storing, of course, the temperature is lower than during annealing. Preferably, a dedicated furnace for storage may be used, which is adapted for individual removal of the wafers for splitting.

Advantageously a hot plate can be used for storing. This is in particular advantageous in the case when the materials of the material compound wafers do not represent a significant difference in thermal expansion coefficients, like for example in the case when the source and handle substrates are made out of the same material or a similar material (for example silicon on insulator-type wafers). In this case the advantage is economical, as hot plates are relatively cheap.

According to a preferred embodiment the source substrate can be made out of a first material and the handle substrate out of a second material, and furthermore the first and second material can be at least one of a group of materials consisting of silicon, an A(III)-B(V)-semiconductor, an alloy of an A(III)-B(V)-semiconductor, Ge, silicon carbide, synthetic quartz or fused silica. Those materials play an important role in today's microelectronic, optoelectronic or micromechanical applications and the demand for high quality but still affordable compound wafers of these materials is high and can be satisfied by the fabrication method according to the invention. Particularly applicable is the invention to silicon on quartz wafers, but also on non-heterogeneous systems such as SOI.

According to the invention, the source-handle compound is cooled down after step c) and then reheated before mechanically split. When a source-handle-compound is cooled down, it is not yet detached but weakened to a certain degree. During said low temperatures, the wafer can be handled and transported to the respective place and equipment where it is further treated. The reheating is conducted up to a degree in which the compound can be further smoothly treated. The mechanical splitting after the product has been reheated leads to a very good surface roughness. It is almost possible to get back to the nominal quality after an appropriate heat treatment, in terms of roughness of the later split surface.

According to a specific aspect of the invention, the source-handle-compound is reheated to a temperature of about 150°C to 250°C, preferably 180° to 220°C, or to about 200°C. In these temperature ranges, the reheating is able to attain a state in which the disadvantageous properties of a cooled down compound are basically cured and the reheated compound is in a state from which the lower detachment temperature can be attained. The resulting wafer of the reheated compound has a good quality and low roughness. The range of 100°C to 220°C has been proved as especially advantageous. 200°C has proven to achieve very good results.

In an advantageous embodiment, the source-handle-compound is reheated for about one to three hours, preferably about two hours. After these reheating times, the source-handle-compound is particularly suited for a good surface roughness attained by splitting.

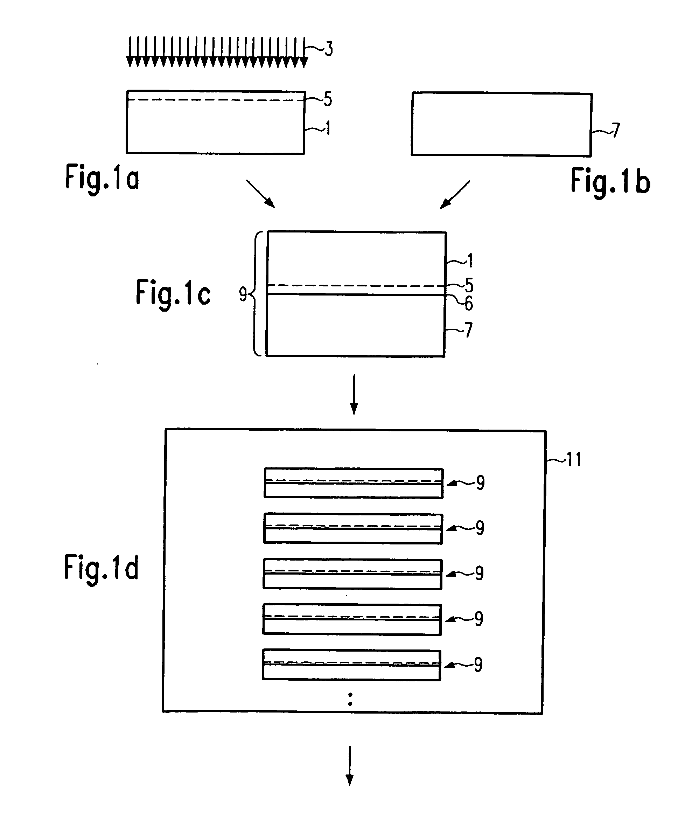

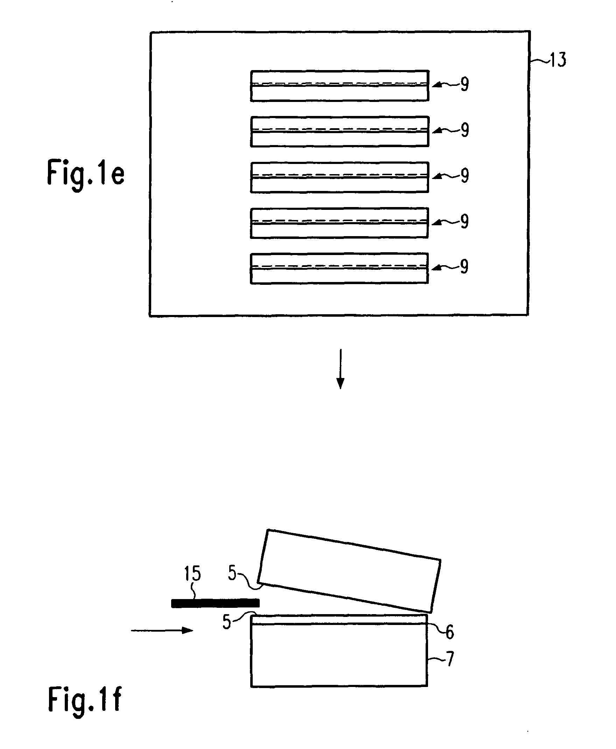

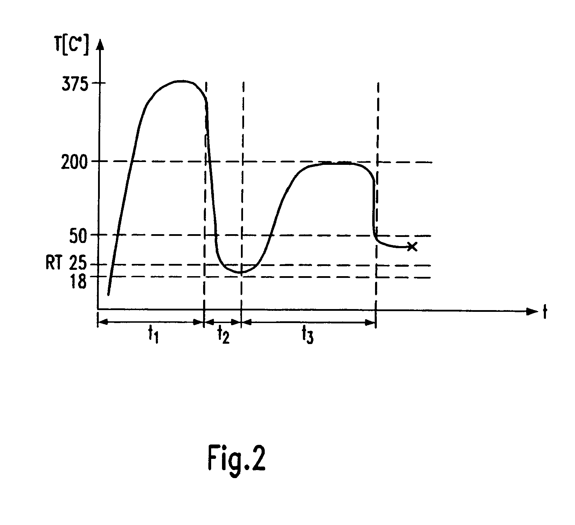

Specific embodiments of the present invention shall become more apparent from the following detailed description with reference to the accompanying drawing in which Fig. 1 schematically shows the steps for carrying out the method for fabricating a material compound wafer according to the invention. Fig. 2 shows a graph from the principle of the temperature of the time of the source-handle-compound according to the invention.

The method for manufacturing material compound wafer according to Fig. 1 is based on SmartCut technology. However, any other process suitable to manufacture a material-compound-wafer and comprising predetermined splitting areas which will be weakened by thermal energy is also applicable.

Step 1a illustrates a source substrate 1, such as for example in this example a silicon wafer of a predetermined size, that is up to 300 mm in diameter for today's wafers, into which atomic species, such as for example hydrogen ions 3 or a combination of H and He or other rare gases are implanted at a predetermined dose and energy. The implanted atomic species create a predetermined splitting area 5 which is substantially in parallel to the surface of the source substrate 1.

Fig. 1b illustrates a handle substrate 7, in this embodiment a wafer of a different material, e.g. a quartz wafer, the surface of which is prepared such that in the following process step, illustrated in Fig. 1c, the handle substrate 7 can be bonded to the source substrate 1 to create the source-handle-compound 9. The source substrate 1 is placed on the handle substrate 7 such that in between the predetermined splitting area 5 and the surface of the handle substrate 7 a thin film 6 of the material of the source substrate and which is to be transferred onto the handle substrate 7, is provided.

The source-handle-compound 9 is then placed into a furnace 11 (see Fig. 1 d) which in this embodiment is a batch type furnace in which several source-handle-compound wafers 9 are annealed at the same time. The process can, however, also be carried out in the same way in a single wafer type furnace. In the furnace 11 the wafers 9 are heated up to a predetermined temperature, which for a silicon on quartz source-handle-compound is of the order of about 300°C to about 500°C. The wafers stay inside the furnace from about a couple of minutes until a couple of hours. Furthermore the annealing can take place at a fixed temperature or a certain temperature profile can be realized inside the furnace to improve the quality.

The annealing step serves only to weaken the predetermined splitting area 5 up to a certain predetermined degree, but is stopped prior to complete detachment. Actually, this is in order to prevent stress inside the source-handle-compound 9 which may arise due to the differences in thermal expansion co-efficient between the source 1 and the handle substrate 7.

After the annealing process the source-handle-compound 9 now with a fragilised splitting area 5 can be transferred into a storage furnace 13, where they are brought to a temperature which is above room temperature but below the annealing temperatures, more precisely at a temperature where essentially no further weakening occurs. This is usually in a range of about 50°C to 150°C, preferably from about 50°C to 140°C and even more preferably from 70°C to about 120°C.

Instead of transferring the wafers 9 into a dedicated storage furnace 13, the wafers could also stay in the furnace 11, shown in Fig. 1d, in which, however, the temperature would have to be lowered to the storage temperature. According to another variant, in the case the differences in thermal expansion coefficients are not too important, hot plates could be used instead of the furnace.

According to yet another variant, storage can occur under a neutral atmosphere, in particular under argon or nitrogen atmosphere to prevent any chemical reactions on the surface or other types of changes to the physical or chemical properties of the source-handle-compound 9.

The next step then consists of carrying out the final detachment of the source substrate at the predetermined splitting area 5 from the remainder of the source-handle-compound. This step is shown in Fig. 1f. Thereto wafers are taken one after the other out of the storage furnace 13 and mechanical energy, in this example by using a blade 15 which is introduced into the source-handle-compound 9 at the level of the weakened predetermined splitting area 5, is applied to the source-handle-compound 9 to provoke the detachment at the predetermined splitting area 5. Thereby the transfer of the thin film 6 of the material of the source substrate is transferred onto the handle substrate 7. Instead of introducing a blade to provide the additional energy, other energy sources could be applied, like e.g. acoustic energy, vibrations, radiation or a stream of liquid under pressure.

For the final detachment, the source-handle-compound 9 is brought to a detachment temperature. Said detachment temperature is higher than room temperature but in which the predetermined splitting area stays with essentially the same degree of weakening. This means that it is a temperature where essentially no further weakening occurs. The compound is held in a state where a mechanical splitting can be performed easily and leads to good surface roughness of the split surface. The detachment temperature is below 150°C, preferably below 50°C. In comparison, the term "room temperature" is in the range of about 18°C to 25°C.

When analyzing the surface quality of the thin film 6 it has been identified that the quality of this surface stays constantly high, independently of when the wafer came out of the storage furnace 13 and does not represent enhanced roughness or lower quality at the circumference in the exclusion zone, in particular at the position where the blade 15 is introduced. Compared to source-handle-compounds that were not detached and/or stored at a temperature higher than room temperature furthermore an overall reduced roughness is observed. This leads to an even further improved quality of the compound material wafers. In particular the low frequency roughness of the surface is improved with respect to the state of the art material compound wafers.

The source-handle-compound 9 is cooled down after the step of the thermal annealing for weakening the predetermined splitting area. It can be cooled down to room temperature or a bit higher than room temperature but also other temperatures are possible. In this state, the compound 9 can be transported over long distances, for example from thermal treatment equipment to mechanical splitting equipment.

In some cases, the compound can even be transported between factories if it has been cooled down.

Subsequently, the source-handle-compound 9, having a weakened splitting area but without being mechanically split yet, is reheated to a temperature of about 150°C to 250°C, preferably 180°C to 220°C or about 200°C. This can be, for example, done in the furnace 13. The reheating may take place for about one to three hours, preferably for about two hours. After the reheating, the source-handle-compound is in a cured state in which individual compounds 9 can be taken out and mechanically split as described above. The reheating enables to obtain a good product quality after mechanical splitting despite the wafers were cooled down after the annealing step.

Fig. 2 shows the graph of the basic course of the temperature T over the time t according to the further embodiment of the invention. In time t1, the thermal annealing of the source-handle-compound 9 takes place for a weakening of the predetermined splitting area. After the annealing, the compound 9 is cooled down to room temperature between 18°C and 25°C, in time t2. The time t2 can take considerably long if the compound is even transported to another factory in this state.

During time t3, the compound is reheated to approximately 200°C, held at this temperature for a period of time and is then again cooled down to a range above room temperature and below 50°C. The cross at the end of the graph marks the mechanical splitting at this stage by means of a blade.

The manufacturing process has been described for the example of a silicon on quartz type material compound wafer. However, the same advantageous process can also be applied to other systems such as, for example, an A(III)-B(V)-semiconductor, or an alloy of an A(III)-B(V)-semiconductor, or a Ge, or a silicon carbide thin film on a synthetic quartz, fused silica or silicon wafer.

The described method is in particular applicable to high volume production, as due to the fact that storing at the predetermined temperature takes place, the time after which the detachment occurs does not play a role on final product quality.

## Claims

1. Method for manufacturing a material compound wafer, in particular a semiconductor on quartz type material compound wafer, comprising the steps of:
a) forming a predetermined splitting area (5) in a source substrate (1),
b) attaching the source substrate (1) to a handle substrate (7) to form a source handle-compound (9),
c) thermal annealing of the source-handle-compound (9) for a weakening of the predetermined splitting area (9), and
d) detachment of the source substrate (1) at the predetermined splitting area (5) by mechanical splitting,
**characterized in that**
in step d) the source-handle-compound (9) is brought to a detachment temperature higher than room temperature (RT), at which the predetermined splitting area (5) stays with essentially the same degree of weakening, and the mechanical splitting is performed at said temperature, wherein room temperature corresponds to a range of 18°C to 25°C,
wherein the source-handle-compound (9) is cooled down after step c) and then reheated before mechanically splitting.

2. Method according to claim 1, wherein the detachment temperature is below 150°C, preferably below 50°C.

3. Method according to claim 1 or 2, wherein the source-handle-compound (9) is stored between step c) and d) at a storing temperature higher than room temperature (RT) at which the predetermined splitting area (5) stays with essentially the same degree of weakening during the storing.

4. Method according to claim 3, wherein storing takes place at a temperature of 50°C to 150°C, in particular of 50°C to 140°C, more in particular from 70°C to 120°C.

5. Method according to claim 3 or 4, wherein storing takes place under an inert atmosphere, in particular under nitrogen and/or argon atmosphere.

6. Method according to one of claims 3 to 5, wherein the annealed source-handle-compound (9) is stored in a furnace (13).

7. Method according to one of claims 3 to 6, wherein the annealed source-handle-compound (9) is stored on a hotplate (13).

8. Method according to one of claims 1 to 7, wherein the source substrate (1) is made out of a first material and the handle substrate (5) out of a second material, and wherein the first and/or second material is at least one of a group of materials consisting of silicon, an A(III)-B(V)-semiconductor, an alloy of an A(III)-B(V)-semiconductor, Ge, silicon carbide, synthetic quartz and fused silica.

9. Method according to claim 1, wherein the source-handle-compound (9) is reheated to a temperature of about 150°C to 250°C, preferably 180°C to 220°C, or to 200°C.

10. Method according to one of claims 1 or 9, wherein the source-handle-compound (9) is reheated for one to three hours, preferably two hours.

## Patentansprüche

1. Verfahren zum Herstellen eines Materialverbindungs-Wafers, insbesondere eines Materialverbindungs-Wafers vom Halbleiter-auf-Quarz-Typ, wobei das Verfahren die folgenden Schritte umfasst:
a) Ausbilden eines vorgegebenen Abtrennbereiches (5) in einem Source-Substrat (1),
b) Anbringen des Source-Substrats (1) an einem Halter-Substrat (handle substrate) (7), um einen Source-Halter-Verbundkörper (9) auszubilden,
c) Wärmebehandlung des Source-Halter-Verbundkörpers (9) zum Abschwächen des vorgegebenen Abtrennbereiches (9), und
d) Ablösung des Source-Substrats (1) an dem vorgegebenen Abtrennbereich (5) durch mechanisches Abtrennen,
**dadurch gekennzeichnet, dass**
in Schritt d) der Source-Halter-Verbundkörper (9) auf eine Ablösungstemperatur über Raumtemperatur (RT) gebracht wird, bei der der vorgegebene Abtrennbereich (5) im Wesentlichen den gleichen Grad an Abschwächung beibehält, und das mechanische Abtrennen bei der Temperatur durchgeführt wird, wobei Raumtemperatur einem Bereich von 18°C bis 25°C entspricht,
wobei der Source-Halter-Verbundkörper (9) nach Schritt c) abgekühlt und dann vor dem mechanischen Abtrennen erneut erhitzt wird.

2. Verfahren nach Anspruch 1, wobei die Ablösetemperatur unter 150°C, vorzugsweise unter 50°C, liegt.

3. Verfahren nach Anspruch 1 oder 2, wobei der Source-Halter-Verbundkörper (9) zwischen Schritt c) und d) bei einer Aufbewahrungstemperatur über Raumtemperatur (RT) aufbewahrt wird, bei der der vorgegebene Abtrennbereich (5) im Wesentlichen den gleichen Grad von Abschwächung während des Aufbewahrens beibehält.

4. Verfahren nach Anspruch 3, wobei das Aufbewahren bei einer Temperatur von 50°C bis 150°C, besonders von 50°C bis 140°C, und insbesondere von 70°C bis 120°C, stattfindet.

5. Verfahren nach Anspruch 3 oder 4, wobei das Aufbewahren in einer inerten Atmosphäre, insbesondere in Stickstoff- und/oder Argon-Atmosphäre, stattfindet.

6. Verfahren nach einem der Ansprüche 3 bis 5, wobei der wärmebehandelte Source-Halter-Verbundkörper (9) in einem Ofen (13) aufbewahrt wird.

7. Verfahren nach einem der Ansprüche 3 bis 6, wobei der wärmebehandelte Source-Halter-Verbundkörper (9) auf einer Heizplatte (13) aufbewahrt wird.

8. Verfahren nach einem der Ansprüche 1 bis 7, wobei das Source-Substrat (1) aus einem ersten Material besteht und das Halter-Substrat (5) aus einem zweiten Material besteht, und wobei das erste und/oder zweite Material wenigstens eines einer Gruppe von Materialien sind/ist, die aus Silizium, einem A(Ill)-B(V)-Halbleiter, einer Legierung aus einem A(III)-B(V)-Halbleiter, Ge, Siliziumcarbid, synthetischem Quarz und Quarzglas besteht.

9. Verfahren nach Anspruch 1, wobei der Source-Halter-Verbundkörper (9) auf eine Temperatur von ungefähr 150°C bis 250°C, vorzugsweise 180°C bis 220°C, oder auf 200°C wiedererhitzt wird.

10. Verfahren nach einem der Ansprüche 1 bis 9, wobei der Source-Halter-Verbundkörper (9) über ein bis drei Stunden, vorzugsweise zwei Stunden, wiedererhitzt wird.

## Revendications

1. Procédé permettant de fabriquer une tranche composite de matériaux, en particulier une tranche composite des matériaux de type semiconducteur sur quartz, comprenant les étapes consistant à :
a) former une zone prédéfinie de séparation (5) dans un substrat formant source (1),
b) fixer le substrat formant source (1) à un substrat intermédiaire (7) afin de former un composite de substrat source - intermédiaire (9),
c) effectuer un recuit thermique du composite de substrat source - intermédiaire (9) en vue d'un affaiblissement de la zone prédéfinie de séparation (5), et
d) séparer le substrat formant source (1) au niveau de la zone prédéfinie de séparation (5) grâce à une division mécanique,
**caractérisé en ce que**
à l'étape d), le composite de substrat source - intermédiaire (9) est amené jusqu'à une température de séparation supérieure à la température ambiante (RT), à laquelle la zone prédéfinie de séparation (5) comporte essentiellement le même degré d'affaiblissement, et la
séparation mécanique est effectuée à ladite température, la température ambiante correspondant à une plage de 18 °C à 25 °C,
dans lequel le composite de substrat source - intermédiaire (9) est refroidi après l'étape c) puis réchauffé avant la division mécanique.

2. Procédé selon la revendication 1, dans lequel la température de séparation se trouve en dessous de 150 °C, de préférence en dessous de 50 °C.

3. Procédé selon la revendication 1 ou 2, dans lequel le composite de substrat source - intermédiaire (9) est stocké entre l'étape c) et l'étape d) à une température de stockage supérieure à la température ambiante (RT) à laquelle la zone prédéfinie de séparation (5) comporte essentiellement le même degré d'affaiblissement pendant le stockage.

4. Procédé selon la revendication 3, dans lequel le stockage est effectué à une température de 50°C à 150 °C, allant en particulier de 50 °C à 140 °C et allant plus en particulier de 70 °C à 120 °C.

5. Procédé selon la revendication 3 ou 4, dans lequel le stockage est effectué sous atmosphère inerte, en particulier sous atmosphère d'azote et/ou d'argon.

6. Procédé selon l'une des revendications 3 à 5, dans lequel le composite de substrat source - intermédiaire (9) recuit est stocké dans un four (13).

7. Procédé selon l'une des revendications 3 à 6, dans lequel le composite de substrat source - intermédiaire (9) recuit est stocké sur une table chauffante (13).

8. Procédé selon l'une des revendications 1 à 7, dans lequel le substrat formant source (1) est constitué d'un premier matériau et le substrat intermédiaire (7) est constitué d'un second matériau, et dans lequel le premier et/ou le second matériau est au moins l'un faisant partie d'un groupe de matériaux constitué de silicium, d'un semiconducteur de type A(III) - B(V), et d'un alliage d'un semiconducteur de type A(III) - B(V), de germanium, de carbure de silicium, de quartz synthétique et de silice fondue.

9. Procédé selon la revendication 1, dans lequel le composite de substrat source - intermédiaire (9) est réchauffé jusqu'à une température d'environ 150 °C à 250 °C, de préférence de 180 °C à 220 °C, ou à 200 °C.

10. Procédé selon l'une des revendications 1 ou 9, dans lequel le composite de substrat source - intermédiaire (9) est réchauffé pendant une à trois heures, de préférence pendant deux heures.
